# EUROPEAN PATENT APPLICATION

(11) **EP 1 777 324 A1**
(43) Date of publication of application: **25.04.2007**
(21) Application number: 05751485.3
(22) Date of filing: 14.06.2005
(51) Int. Cl.: C30B 29/22, C23C 14/08, H01B 12/06, H01B 13/00

(54) **THIN FILM MATERIAL AND METHOD FOR MANUFACTURING THE SAME**

(30) Priority: 16.07.2004 JP 2004210023
(71) Applicant: Sumitomo Electric Industries, Ltd., Osaka-shi, Osaka 541-0041 (JP); International Superconductivity Technology Center, The Juridical Foundation, Tokyo 105-0004 (JP)
(72) Inventor: HAHAKURA, S., Osaka Wrks, SUMITOMO ELEC. IND. LTD., Osaka-shi, Osaka 5548511 (JP); OHMATSU, K., Osaka Wrks, SUMITOMO ELEC. IND. LTD., Osaka-shi, Osaka 5548511 (JP)
(74) Representative: Joly, Jean-Jacques
(86) International application number: PCT/JP2005/010831
(87) International publication number: WO 2006/008893

(57) **Abstract**

A thin film material and a method of manufacturing the thin film material are obtained with which properties of films formed on a substrate can be improved. A superconducting wire 1 includes a substrate 2, an intermediate thin film layer (intermediate layer 3) formed on the substrate and comprised of one layer or at least two layers, and a single-crystal thin film layer (superconducting layer 4) formed on the intermediate thin film layer (intermediate layer 3). An upper surface (ground surface 10) that is the upper surface of at least one layer of the intermediate thin film layer (intermediate layer 3) and is opposite to the single-crystal thin film layer (superconducting layer 4) is ground.

## Description

### Technical Field

The present invention relates to a thin film material and a method of manufacturing the thin film material. More specifically, the invention relates to a thin film material having a single-crystal thin film layer excellent in crystallinity as well as a method of manufacturing the thin film material.

### Background Art

There are conventional thin film materials that are known, for example, as a superconducting thin film wire having, as an example of a single-crystal thin film layer, a superconducting layer formed directly on a substrate (see for example Japanese Patent Laying-Open Nos. 6-31604 (Patent Document 1), 6-68727 (Patent Document 2) and 6-68728 (Patent Document 3)) as well as a superconducting thin film wire having an intermediate thin film layer and a superconducting layer that are formed on a substrate (see for example "Development of High-Temperature Superconducting Thin Film Tape Using the ISD Method," Fujino and six other authors, SEI Technical Review, September 1999, Vol. 155, pp. 131-135 (Non-Patent Document 1)).

Regarding such superconducting thin film wires as mentioned above, it is proposed to grind a surface of the substrate in advance for the purpose of forming such a single-crystal thin film layer as superconducting layer that has excellent properties (for example high critical current density) (see Patent Documents 1 to 3).
Patent Document 1: Japanese Patent Laying-Open No. 6-31604
Patent Document 2: Japanese Patent Laying-Open No. 6-68727
Patent Document 3: Japanese Patent Laying-Open No. 6-68728
Non-Patent Document 1: "Development of High-Temperature Superconducting Thin Film Tape Using the ISD Method," Fujino and six other authors, SEI Technical Review, September 1999, Vol. 155, pp. 131-135

### Disclosure of the Invention

### Problems to be Solved by the Invention

Regarding the above-described superconducting thin film wire having the intermediate thin film layer and the superconducting layer formed on the substrate, in the case where the intermediate thin film layer is formed on a surface of the substrate that has been ground and thereafter the superconducting layer is formed on the intermediate thin film layer, it is difficult to sufficiently improve the in-plane orientation of the superconducting layer formed as an example of a single-crystal thin film layer, since the surface of the intermediate thin film layer has not particularly undergone such a process as planarization. Consequently, there remains a problem that properties of the single-crystal thin film layer thus formed (for example, if the formed single-crystal thin film layer is a superconducting layer, such a property as critical current density of the superconducting layer) are not sufficiently improved.

The present invention is made to solve such a problem as describe above. An object of the present invention is to provide a thin film material and a method of manufacturing the thin film material with which properties of a single-crystal thin film layer formed on a substrate can be improved.

### Means for Solving the Problems

A thin film material according to the present invention includes a substrate, an intermediate thin film layer formed on the substrate and comprised of one layer or at least two layers, and a single-crystal thin film layer formed on the intermediate thin film layer. An upper surface that is an upper surface of at least one layer of the intermediate thin film layer and that is opposite to the single-crystal thin film layer is ground.

Thus, the upper surface of the intermediate thin film layer that is opposite to the overlying thin film layer is ground to be smoothed, and accordingly such properties as surface smoothness and in-plane orientation of the single-crystal thin film layer formed on the ground upper surface can be improved.

A superconducting thin film material according to the present invention includes a substrate, an intermediate thin film layer formed on the substrate and comprised of one layer or at least two layers, and a single-crystal thin film layer formed on the intermediate thin film layer. A surface (upper surface) that is a surface of the intermediate thin film layer and that is in contact with the single-crystal thin film layer is ground.

Thus, the surface of the intermediate thin film layer that is in contact with the single-crystal thin film layer is ground to be smoothed, and accordingly such properties as surface smoothness and in-plane orientation of the single-crystal thin film layer formed on the ground surface can be improved. In the case where a superconducting thin film layer for example is formed as the single-crystal thin film layer, the improved surface smoothness and in-plane orientation of the single-crystal thin film layer (superconducting thin film layer) can provide improvements in such properties as critical current value and critical current density of the superconducting thin film layer.

A superconducting thin film material according to the present invention includes a substrate, an intermediate thin film layer and a single-crystal thin film layer formed on the intermediate thin film layer. The intermediate thin film layer includes a lower intermediate thin film layer formed on the substrate and comprised of one layer or at least two layers, and an upper intermediate thin film layer formed on the lower intermediate thin film layer and comprised of one layer or at least two layers. A surface (upper surface) that is a surface of the lower intermediate thin film layer and that is in contact with the upper intermediate thin film layer is ground.

Thus, the upper surface of the lower intermediate thin film layer is ground to be planarized, and accordingly the planarity of the upper surface of the upper intermediate thin film layer (upper surface opposite to the single-crystal thin film layer) is also improved. Therefore, such properties as surface smoothness and in-plane orientation of the single-crystal thin film layer formed on the upper intermediate thin film layer can be improved. In the case where a superconducting thin film layer for example is formed as the single-crystal thin film layer, the improved surface smoothness and in-plane orientation of the superconducting thin film layer can provide improvements in such properties as critical current value and critical current density of the superconducting thin film layer.

A method of manufacturing a thin film material according to the present invention includes the steps of preparing a substrate, forming an intermediate thin film layer comprised of one layer or at least two layers on the substrate, processing by grinding an uppermost surface of the intermediate thin film layer, and forming a single-crystal thin film layer on the uppermost surface of the intermediate thin film layer that is ground in the processing step.

Thus, the thin film material of the present invention can easily be manufactured. Further, since the single-crystal thin film layer can be formed on the uppermost surface of the intermediate thin film layer that has been ground to exhibit excellent planarity, the surface smoothness and in-plane orientation of the single-crystal thin film layer can be improved.

A method of manufacturing a thin film material according to the present invention includes the steps of preparing a substrate, forming a lower intermediate thin film layer comprised of one layer or at least two layers on the substrate, processing by grinding an uppermost surface of the lower intermediate thin film layer, forming an upper intermediate thin film layer comprised of one layer or at least two layers on the uppermost surface of the lower intermediate thin film layer that is ground in the processing step, and forming a single-crystal thin film layer on the upper intermediate thin film layer.

Thus, the thin film material of the present invention can easily be manufactured. Further, since the uppermost surface (upper surface) of the lower intermediate thin film layer is ground to be planarized, the planarity of the upper surface of the upper intermediate thin film layer (surface opposite to the single-crystal thin film layer) is also improved. Accordingly, such properties as surface smoothness and in-plane orientation of the single-crystal thin film layer formed on the upper intermediate thin film layer can be improved.

### Effects of the Invention

As discussed above, according to the present invention, a thin film material having a single-crystal thin film layer excellent in surface smoothness and in-plane orientation can be obtained.

### Brief Description of the Drawings

Fig. 1 is a schematic partial cross-sectional view showing a first embodiment of a superconducting wire according to the present invention.
Fig. 2 is a flowchart illustrating a method of manufacturing the superconducting wire shown in Fig. 1.
Fig. 3 is a schematic partial cross-sectional view showing a modification of the first embodiment of the superconducting wire shown in Fig. 1.
Fig. 4 is a flowchart illustrating a method of manufacturing the superconducting wire shown in Fig. 3.
Fig. 5 is a schematic partial cross-sectional view showing a second embodiment of the superconducting wire according to the present invention.
Fig. 6 is a flowchart illustrating a method of manufacturing the superconducting wire shown in Fig. 5.
Fig. 7 is a schematic partial cross-sectional view showing a third embodiment of the superconducting wire according to the present invention.
Fig. 8 is a flowchart illustrating a method of manufacturing the superconducting wire shown in Fig. 7.
Fig. 9 is a schematic partial cross-sectional view showing a modification of the third embodiment of the superconducting wire of the present invention shown in Fig. 7.
Fig. 10 is a schematic partial cross-sectional view showing Example 2 of the superconducting wire according to the present invention.

### Description of the Reference Signs

1 superconducting wire, 2 substrate, 3, 3a-3f intermediate layer, 4 superconducting layer, 10, 20 ground surface, 30, 40 upper surface

### Best Modes for Carrying Out the Invention

With reference to the drawings, embodiments of the present invention are hereinafter described. In the following drawings, like or corresponding components are denoted by like reference numerals and the description thereof is not repeated.

### First Embodiment

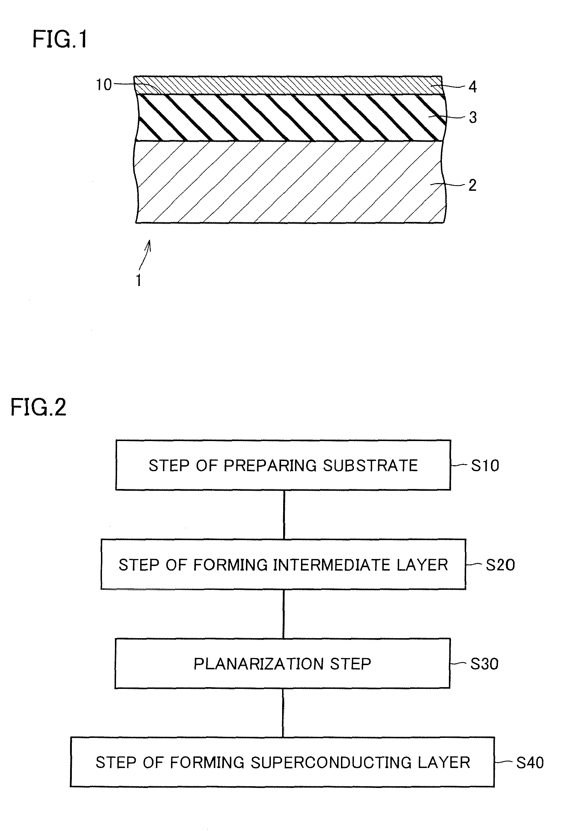

Referring to Figs. 1 and 2, a first embodiment of a superconducting wire of the present invention is described.

As shown in Fig. 1, a superconducting wire 1 is comprised of a substrate 2, an intermediate layer 3 and a superconducting layer 4. Substrate 2 is in the shape of a long strip. The upper surface of intermediate layer 3 is a surface having undergone a grinding process, namely a ground surface 10. Thus, superconducting layer 4 is formed on the upper surface (ground surface 10) of intermediate layer 3 that is superior in surface smoothness, and accordingly superconducting layer 4 is improved in surface smoothness and in-plane orientation. Consequently, superconducting wire 1 that exhibits excellent superconducting properties (critical current value and critical current density) can be obtained.

Referring then to Fig. 2, a method of manufacturing superconducting wire 1 shown in Fig. 1 is described. According to the method of manufacturing superconducting wire 1 shown in Fig. 1, the step of preparing the substrate is first carried out as shown in Fig. 2 (S10). Specifically, substrate 2 serving as a base for superconducting wire 1 is prepared. As this substrate 2, a strip-shaped metal tape made of such a metal as nickel may be employed.

Next, the step of forming the intermediate layer is carried out (S20). In this step of forming the intermediate layer (S20), intermediate layer 3 made of an oxide is formed on the prepared substrate 2. For this intermediate layer 3, an oxide having such a crystal structure as rock salt type, fluorite type, perovskite type or pyrochlore type structure for example may be employed. As a film deposition method to be employed in the step of forming intermediate layer 3 (S20), an arbitrary film deposition method may be employed. For example, such a physical vapor deposition method as pulsed laser deposition (PLD) may be employed.

Then, the planarization step is performed (S30). In this planarization step (S30), CMP (Chemical Mechanical Polishing) is used to remove the upper surface layer of the aforementioned intermediate layer 3 by a predetermined thickness so as to accomplish the planarization. As a method to be employed for the planarization, any arbitrary method such as wet etching or mechanical polishing may be used instead of the aforementioned CMP.

At this time, the surface roughness (Ra) of ground surface 10 (see Fig. 1) of the planarized intermediate layer 3 is at most 20 nm and more preferably at most 5 nm.

After this, the step of forming the superconducting layer on intermediate layer 3 with its upper surface planarized is performed (S40). As a film deposition method to be employed in the step of forming superconducting layer 4 (S40), any arbitrary film deposition method may be employed. As employed in forming intermediate layer 3, such a physical vapor deposition method as pulsed laser deposition may be employed. Further, in the step of forming superconducting layer 4, the aforementioned PLD or ISD may be employed.

In this way, the superconducting wire shown in Fig. 1 can be obtained.

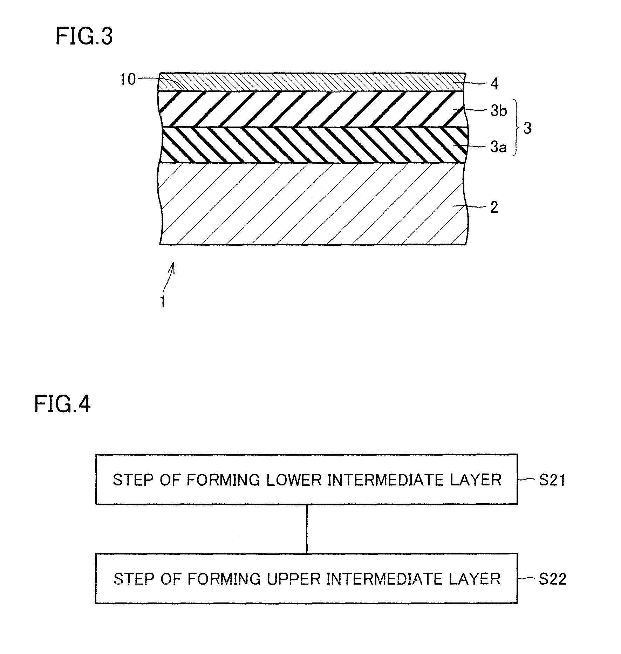

Referring to Fig. 3, a modification of the first embodiment of the superconducting wire of the present invention is described.

A superconducting wire 1 shown in Fig. 3 is basically structured similarly to superconducting wire 1 shown in Fig. 1 except for the structure of intermediate layer 3. Specifically, in superconducting wire 1 shown in Fig. 3, intermediate layer 3 is comprised of two layers that are a lower intermediate layer 3a and an upper intermediate layer 3b. The upper surface of upper intermediate layer 3b is a ground surface 10 having undergone grinding, like the upper surface of intermediate layer 3 shown in Fig. 1. This superconducting wire 1 structured in the above-described manner can also provide similar effects to those of the superconducting wire shown in Fig. 1.

Referring to Figs. 4 and 2 showing flowcharts illustrating the method of manufacturing the superconducting wire, a method of manufacturing superconducting wire 1 shown in Fig. 3 is described. Here, Fig. 4 illustrates a process of forming intermediate layer 3 of superconducting wire 1 shown in Fig. 3.

First, the step of preparing the substrate shown in Fig. 2 is performed (S10). After this, as the step of forming the intermediate layer, the step of forming the lower intermediate layer shown in Fig. 4 is performed (S21). In this step of forming lower intermediate layer 3 a (S21), an arbitrary film deposition method may be employed, as the method used in the step of forming the intermediate layer shown in Fig. 2 (S20).

Second, the step of forming the upper intermediate layer is performed (S22). In this step of forming upper intermediate layer 3b (S22) as well, an arbitrary film deposition method may be employed.

Then, the planarization step for planarizing the upper surface of upper intermediate layer 3b (S30) (see Fig. 2) and the step of forming the superconducting layer (S40) (see Fig. 2) may be performed. Thus, the superconducting wire shown in Fig. 3 can be obtained.

### Second Embodiment

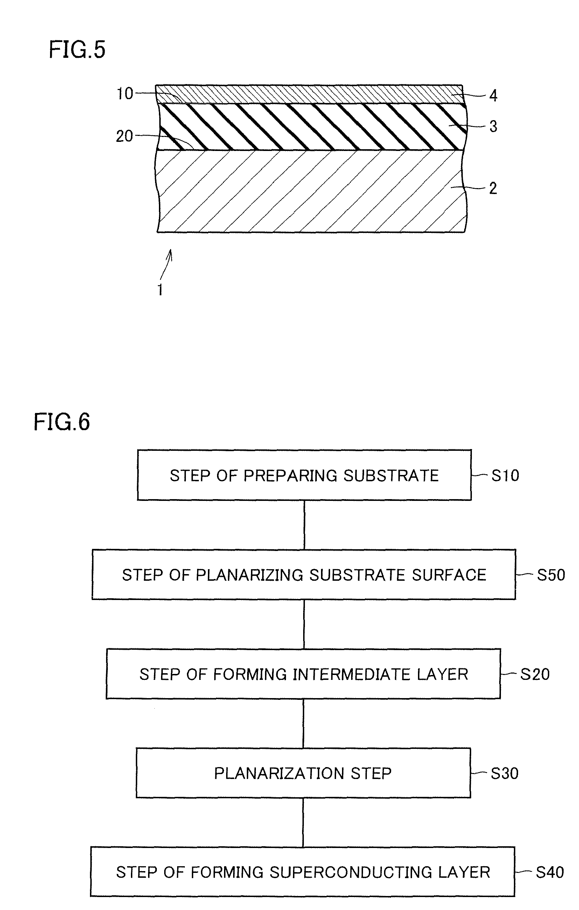

Referring to Fig. 5, a second embodiment of the superconducting wire of the present invention is described.

As shown in Fig. 5, a superconducting wire 1 is basically structured similarly to superconducting wire 1 shown in Fig. 1, except that the upper surface of a substrate 2 is a ground surface 20 that is ground to be planarized. In this way as well, similar effects to those of the superconducting wire shown in Fig. 1 can be provided. Further, since the upper surface of substrate 2 is also planarized, the in-plane orientation of a superconducting layer 4 that is formed at the uppermost level can further be improved. Consequently, the critical current value as well as the critical current density of superconducting layer 4 can further be increased.

Referring to Fig. 6, a method of manufacturing the superconducting wire shown in Fig. 5 is described.

According to the method of manufacturing the superconducting wire shown in Fig. 6, the step of preparing the substrate is first performed (S10), as done for the method of manufacturing the superconducting wire shown in Fig. 2. Then, the planarization step for planarizing the substrate surface is performed (S50). In this planarization step (S50), an arbitrary planarization method may be employed. For example, any of such methods as CMP, wet etching and mechanical polishing for example may be employed.

Here, ground surface 20 of substrate 2 as planarized has a surface roughness (Ra) of at most 20 nm, more preferably at most 5 nm.

After this, similarly to the method of manufacturing the superconducting wire shown in Fig. 2, the step of forming the intermediate layer (S20), the planarization step for planarizing by grinding the upper surface of the intermediate layer (S30), and the step of forming the superconducting layer (S40) are performed. In this way, superconducting wire 1 shown in Fig. 5 can be obtained

### Third Embodiment

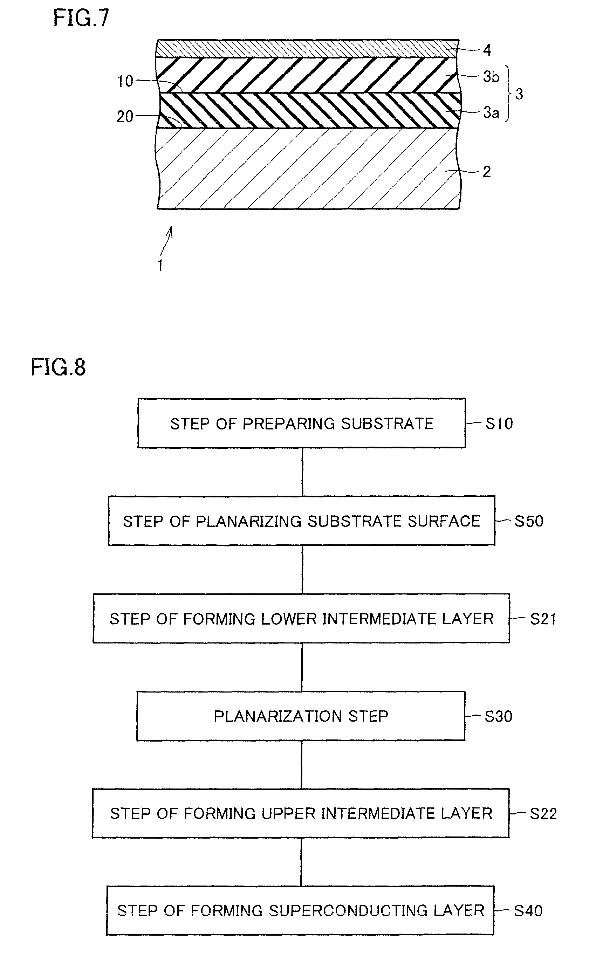

Referring to Fig. 7, a third embodiment of the superconducting wire of the present invention is described.

A superconducting wire 1 shown in Fig. 7 is basically structured similarly to the superconducting wire shown in Fig. 3, except that a ground surface 10 is formed at the upper surface of a lower intermediate layer 3a in an intermediate layer 3, instead of the upper surface of an upper intermediate layer 3b in intermediate layer 3, and that the upper surface of a substrate 2 is ground to form a ground surface 20. Superconducting wire 1 structured in the above-described manner also provides effects similar to those of superconducting wire 1 shown in Fig. 3. Further, since the upper surface of substrate 2 is also the planarized ground surface 20, the planarity of the upper surface of intermediate layer 3 can further be improved. Consequently, the in-plane orientation of a superconducting layer 4 can further be improved. Accordingly, such properties as critical current value and critical current density of superconducting layer 4 can further be improved.

Referring to Fig. 8, a method of manufacturing superconducting wire 1 shown in Fig. 7 is described.

As shown in Fig. 8, according to the method of manufacturing the superconducting wire, the step of preparing the substrate is first performed (S10) similarly to the method of manufacturing the superconducting wire shown in Fig. 2. Then, as the method of manufacturing the superconducting wire shown in Fig. 6, the planarization step for the substrate surface is performed (S50). For this planarization step (S50), an arbitrary planarization method may be employed. For example, CMP may be employed to remove the surface layer of substrate 2 by a predetermined thickness.

After this, the step of forming the lower intermediate layer on ground surface 20 of substrate 2 is performed (S21). Thus, lower intermediate layer 3a (see Fig. 7) is formed.

Subsequently, the planarization step (S30) is performed by using the polishing for example to partially remove the upper surface of the lower intermediate layer and thereby accomplish planarization. For this planarization step (S30), CMP for example may be employed. In this way, at the upper surface of lower intermediate layer 3 a, ground surface 10 (see Fig. 7) is formed.

Following this, the step of forming upper intermediate layer 3b on ground surface 10 of lower intermediate layer 3a is performed (S22). Here, for the step of forming the lower intermediate layer (S21) and the step of forming the upper intermediate layer (S22), an arbitrary film deposition method may be employed. For example, such a physical vapor deposition as pulsed laser deposition may be employed.

Then, the step of forming superconducting layer 4 on upper intermediate layer 3b is performed (S40). In this way, the superconducting wire shown in Fig. 7 can be obtained.

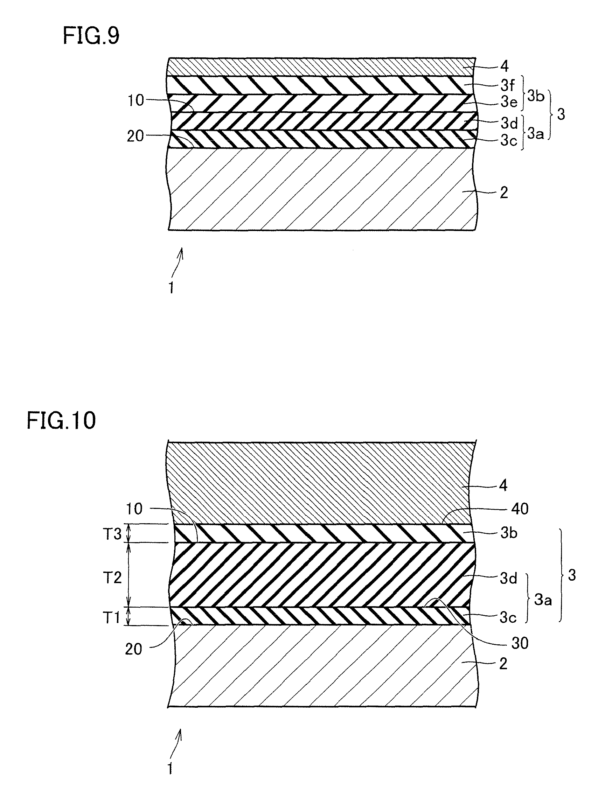

It is noted that, as shown in Fig. 9, each of lower intermediate layer 3 a and upper intermediate layer 3b may be comprised of a plurality of layers (two layers in Fig. 9). Referring to Fig. 9, a modification of superconducting wire 1 shown in Fig. 7 is described.

As shown in Fig. 9, superconducting wire 1 is basically structured similarly to superconducting wire 1 shown in Fig. 7, except for the structure of lower intermediate layer 3 a and upper intermediate layer 3b. Specifically, in superconducting wire 1 shown in Fig. 9, lower intermediate layer 3 a is comprised of a first intermediate layer 3c formed on ground surface 20 of substrate 2 and a second intermediate layer 3d formed on this first intermediate layer 3c. Further, the upper surface of the second intermediate layer 3d is a ground surface 10. Furthermore, upper intermediate layer 3b shown in Fig. 9 is comprised of a third intermediate layer 3e formed on the second intermediate layer 3d and a fourth intermediate layer 3f formed on the third intermediate layer 3e.

Superconducting wire 1 structured in the above-described manner also provides effects similar to those of superconducting wire 1 shown in Fig. 7.

While upper intermediate layer 3b and lower intermediate layer 3 a shown in Fig. 9 are each comprised of a plurality of layers (two layers in Fig. 9, however, upper intermediate layer 3 and lower intermediate layer 3 a each may be comprised of an arbitrary number of layers that is at least three), lower intermediate layer 3 a may be comprised of a plurality of layers while upper intermediate layer 3b may be of a single layer as shown in Fig. 7. On the contrary, upper intermediate layer 3b may be comprised of a plurality of layers and lower intermediate layer 3a may be of a single layer as shown in Fig. 7.

The characteristic structures of the superconducting wire, as an example of the thin-film material, according to the invention as described above, are summarized as follows. Superconducting wire 1 shown in Figs. 1, 3, 5, 7 and 9 as the thin film material includes a substrate 2, an intermediate thin film layer (intermediate layer 3) formed on the substrate and comprised of one layer or at least two layers, and a single-crystal thin film layer (superconducting layer 4) formed on the intermediate thin film layer (intermediate layer 3). An upper surface (ground surface 10 as shown in Figs. 1, 3 and 5 for example) that is an upper surface of at least one layer of the intermediate thin film layer (intermediate layer 3) and that is opposite to the single-crystal thin film layer (superconducting layer 4) is ground. Thus, the upper surface of intermediate layer 3 that is opposite to superconducting layer 4 is ground to be smoothed, and accordingly such properties as surface smoothness and in-plane orientation of superconducting layer 4 formed on the ground upper surface (ground surface 10) can be improved.

Superconducting wire 1 as the thin film material according to the present invention includes, as shown for example in Figs. 1, 3 and 5, a substrate 2, an intermediate thin film layer (intermediate layer 3) formed on the substrate and comprised of one layer or at least two layers, and a single-crystal thin film layer (superconducting layer 4) formed on the intermediate thin film layer (intermediate layer 3). A surface (ground surface 10) that is a surface of the intermediate thin film layer (intermediate layer 3) and that is in contact with the single-crystal thin film layer (superconducting layer 4) is ground.

Thus, the upper surface (ground surface 10) of the intermediate thin film layer (intermediate layer 3) that is opposite to superconducting layer 4 is ground to be smoothed, and accordingly such properties as surface smoothness and in-plane orientation of the single-crystal thin film layer (superconducting layer 4) formed on the ground upper surface (ground surface 10) can be improved. Accordingly, the improved surface smoothness and in-plane orientation of superconducting layer 4 can provide improvements in such properties as critical current value and critical current density of superconducting wire 1.

Superconducting wire 1 as the thin film material according to the present invention includes, as shown in Figs. 7 and 9, a substrate 2, an intermediate thin film layer (intermediate layer 3) and a single-crystal thin film layer (superconducting layer 4) formed on intermediate layer 3. Intermediate layer 3 includes a lower intermediate thin film layer formed on substrate 2 and comprised of one layer or at least two layers (lower intermediate layer 3a shown in Fig. 7 or lower intermediate layer 3a comprised of first and second intermediate layers 3c, 3d shown in Fig. 9) and an upper intermediate thin film layer formed on the lower intermediate thin film layer (lower intermediate layer 3 a) and comprised of one layer or at least two layers (upper intermediate layer 3b shown in Fig. 7 or lower intermediate layer 3b comprised of third and fourth intermediate layers 3e, 3f shown in Fig. 9). An upper surface (ground surface 10) that is an upper surface of the lower intermediate thin film layer (lower intermediate layer 3a) and that is in contact with the upper intermediate thin film layer (upper intermediate layer 3b) is ground.

Thus, the upper surface of lower intermediate layer 3a is ground to be planarized, and accordingly the upper surface (surface opposite to superconducting layer 4) of upper intermediate layer 3b can be improved in planarity. Therefore, such properties as surface smoothness and in-plane orientation of the single-crystal thin film layer (superconducting layer 4) formed on this upper intermediate layer 3b can be improved. The improved surface smoothness and in-plane orientation of superconducting layer 4 can provide improvements in such properties as critical current value and critical current density of superconducting layer 4.

Regarding the above-described superconducting wire 1, as shown for example in Figs. 5, 7 and 9, the upper surface (ground surface 20) of substrate 2 that is opposite to the intermediate thin film layer (intermediate layer 3) may be ground. In this case, since the upper surface of substrate 2 is ground in advance, the upper surface (opposite to superconducting layer 4) of intermediate layer 3 formed on the ground surface (ground surface 20) or the upper surface of lower intermediate layer 3a that is a component of intermediate layer 3 as shown in Fig. 7 can be improved in planarity. Thus, in the case where the grinding step (planarization step (S30) shown in Fig. 6) is performed on the upper surface of intermediate layer 3 that is opposite to superconducting layer 4 or the grinding step (planarization step (S30) shown in Fig. 8) is performed on the upper surface of lower intermediate layer 3a, sufficient planarity can be implemented while an amount of grinding is kept small. In this way, the time consumed for the process of manufacturing superconducting wire 1 can be shortened and consequently the manufacturing cost of superconducting wire 1 can be reduced.

Further, when the upper surface of intermediate layer 3 or the upper surface of lower intermediate layer 3a is to be ground, as ground in the case where the surface of substrate 2 is not ground, the planarity of the upper surface of intermediate layer 3 (or upper surface of lower intermediate layer 3a) is ensured to a degree before the upper surface of the intermediate or lower intermediate layer is ground. Therefore, the planarity of the upper surface of intermediate layer 3 (or upper surface of lower intermediate layer 3 a) and the orientation of intermediate layer 3 can further be improved. Accordingly, such properties as the surface smoothness and in-plane orientation of the single-crystal thin film layer (superconducting layer 4) formed on the intermediate thin film layer (intermediate layer 3) can further be improved.

Regarding the above-described thin film material (superconducting wire 1), the single-crystal thin film layer (superconducting layer 4) is a superconducting thin film layer. In this case, as the structure of superconducting wire 1 provided as a thin film material, the structure of the thin film material of the present invention may be used. Therefore, the superconducting thin film layer (superconducting layer 4) may be formed as the single-crystal thin film layer as shown in Figs. 1 and 3 for example, so as to obtain the superconducting thin film layer (superconducting layer 4) that is excellent in surface smoothness and in-plane orientation. Accordingly, the superconducting thin film layer (superconducting layer 4) that is excellent in such properties as critical current value and critical current density can be obtained.

Regarding the above-described superconducting wire 1, substrate 2 may be made of a metal. Further, substrate 2 may be in the shape of a long strip. Intermediate layer 3 may be made of an oxide having a crystal structure of one of rock salt type, fluorite type, perovskite type and pyrochlore type. For example, intermediate layer 3 may be made of YSZ (yttria-stabilized zirconia), an oxide of a rare earth element like CeO₂, BZO (BaZrO₃), STO (SrTiO₃) or Al₂O₃ for example. As shown in Figs. 3, 7 and 9, in the case where intermediate layer 3 is comprised of a plurality of layers, intermediate layers 3a to 3f constituting intermediate layer 3 may be made of respective materials different from each other. Superconducting layer 4 may be made of an RE-123 type superconductor. Thus, since intermediate layer 3 and superconducting layer 4 are formed on substrate 2 made of a flexible metal, superconducting wire 1 that is easy to deform, bend, for example, and that serves as a superconducting thin film material having large critical current value and critical current density can be implemented.

As a method of manufacturing a thin film material according to the present invention, a method of manufacturing superconducting wire 1 includes the steps of preparing a substrate (S 10), forming an intermediate layer 3 as an intermediate thin film layer 3 comprised of one layer or at least two layers on the substrate (S20, S21, S22), processing by grinding an uppermost surface of intermediate layer 3 (planarization step S30 in Figs. 2 and 6), and forming a single-crystal thin film layer on the uppermost surface (ground surface 10) of intermediate layer 3 that is ground in the processing step, namely the step of forming superconducting layer 4 as a superconducting thin film layer (the step of forming the superconducting layer in Figs. 2 and 6) (S40). Thus, superconducting wire 1 as the thin film material of the present invention can easily be manufactured. Further, since the single-crystal thin film layer (superconducting layer 4) can be formed on the uppermost surface of intermediate layer 3 that is ground to exhibit excellent planarity, the surface smoothness and in-plane orientation of superconducting layer 4 can be improved. Accordingly, such characteristics as critical current value and critical current density of superconducting layer 4 can be improved.

As a method of manufacturing a thin film material according to the present invention, a method of manufacturing superconducting wire 1 includes the steps of preparing a substrate (S10), forming a lower intermediate layer 3 a as a lower intermediate thin film layer comprised of one layer or at least two layers on the substrate (step S21 in Fig. 8), processing by grinding the uppermost surface of lower intermediate layer 3a (planarization step S30 in Fig. 8), forming an upper intermediate thin film layer (upper intermediate layer 3b) comprised of one layer or at least two layers on the uppermost surface of lower intermediate layer 3 a that is ground in the processing step (step S22 in Fig. 8), and forming a single-crystal thin film layer (superconducting layer 4) on upper intermediate layer 3b, namely forming a superconducting thin film layer (step S40 of forming the superconducting layer in Fig. 8). In this way, superconducting wire 1 of the present invention can easily be manufactured. Further, since the uppermost surface (upper surface) of lower intermediate layer 3a is ground to be planarized, the planarity of the upper surface (surface opposite to superconducting layer 4) of upper intermediate layer 3b is also improved. Thus, such properties as surface smoothness and in-plane orientation of superconducting layer 4 formed on this upper intermediate layer 3b can be improved. Accordingly, such properties as critical current value and critical current density of superconducting layer 4 can be improved.

The method of manufacturing superconducting wire 1 discussed above further includes the substrate processing step for grinding a surface of substrate 2 (planarization step S50 for the substrate surface shown in Figs. 6 and 8). In this case, since the surface of substrate 2 is ground in advance, the planarity of the surface (opposite to superconducting layer 4) of intermediate layer 3 that is formed on the ground surface (ground surface 20) or the planarity of the upper surface of lower intermediate layer 3a as a component of intermediate layer 3 can be improved. Thus, in the case where the upper surface of intermediate layer 3 that is opposite to superconducting layer 4 is ground or the upper surface of lower intermediate layer 3 a is ground, sufficient planarity can be implemented while keeping an amount of grinding small. Further, when the upper surface of intermediate layer 3 or the upper surface of lower intermediate layer 3a is to be ground, as ground in the case where the surface of substrate 2 is not ground, since the planarity of the upper surface of in intermediate layer 3 (or upper surface of lower intermediate layer 3a) is ensured to a degree before the upper surface of the intermediate or lower intermediate layer is ground, the planarity of the upper surface of intermediate layer 3 (or upper surface of lower intermediate layer 3a) as well as the orientation of the intermediate thin film layer can further be improved.

### Example 1

In order to confirm the effects of the present invention, the following experiment was conducted. Specifically, a sample of a Comparative Example as well as samples 1, 2 of Examples were prepared and the critical current density of the superconducting layer of each sample was measured, as indicated below. Table 1 shows a part of properties and the value of the measured critical current density of each sample.

**[Table 1]**

| | Comparative Example | Example 1 | Example 2 |
|---|---|---|---|
| substrate grinding | not performed | not performed | performed |
| intermediate-layer grinding | not performed | performed | performed |
| surface roughness of substrate (nm) | 98 | 98 | 2.5 |
| surface roughness of intermediate layer (nm) | 112 | 8.5 | 2.1 |
| full width at half-maximum of the intermediate layers ΔΦ (°) | 12.8 | 10.1 | 8.1 |
| critical current density of superconducting layer (MA/cm²) | 0 | 0.7 | 2.1 |

In Comparative Example and Examples 1 and 2, the substrate, the intermediate layer formed on the substrate and the superconducting layer formed on the intermediate layer form the three-layer structure as shown in Fig. 1. As the substrate, a nickel (Ni) alloy substrate was used. This Ni alloy substrate had a surface roughness (Ra) of 98 nm. As the intermediate layer, yttria-stabilized zirconia (YSZ) was deposited by pulsed laser deposition on the Ni alloy substrate. The YSZ had a thickness of 1 µm. Further, as the superconducting layer, an oxide superconductor of HoBa₂Cu₃O_{y} (y is approximately 6 to 7, more preferably approximately 7) was used. This material is hereinafter simply referred to as HoBCO. This superconducting layer was deposited by pulsed laser deposition to a film thickness of 0.25 µm in each of Comparative Example and Examples 1, 2.

The structure of each sample was confirmed. Regarding the sample of the Comparative Example, on the Ni alloy substrate as indicated above, YSZ was directly deposited as the intermediate layer to 1 µm without such processing as surface grinding of the substrate. Then, without such processing as grinding of the upper surface of the intermediate layer of YSZ, the HoBCO superconducting layer was deposited by pulsed laser deposition to a thickness of 0.25 µm on the intermediate layer.

As for the sample of Example 1, on the Ni alloy substrate, the YSZ as the intermediate layer was deposited by pulsed laser deposition to 1 µm as done for the sample of the Comparative Example. Then, the upper surface of this intermediate layer was ground by CMP to remove the upper surface by a thickness of 0.25 µm. This grinding process may be a two-step grinding process. Specifically, the first step is CMP using a common slurry for removing the upper surface of the intermediate layer by a predetermined thickness and the subsequent second step is grinding the upper surface of the intermediate layer using an abrasive cloth together with water instead of slurry (mechanical grinding). According to this approach, the common slurry is first used to perform normal CMP so as to carry out the grinding at a certain grinding rate (the thickness removed by grinding per unit time), thereafter the mechanical grinding is performed using water instead of slurry, and thus the precision in controlling the thickness removed by grinding can be improved, while the grinding rate decreases. Accordingly, both of the shortened processing time required for grinding and the improvement in precision in controlling the removed thickness can simultaneously be implemented to a degree. Further, for this grinding, any mechanical grinding method may be employed instead of CMP or another arbitrary method (wet etching for example) may be employed. On this intermediate layer having undergone this grinding, the HoBCO superconducting layer was deposited by pulsed laser deposition to a film thickness of 0.25 µm as done in the Comparative Example.

As for the sample of Example 2, the surface of the Ni alloy substrate was ground by CMP for surface grinding of the substrate. In this grinding process for the surface of the Ni alloy substrate, any arbitrary grinding method that is applicable to the grinding process for the intermediate layer discussed above may be used. Further, in the grinding process for the substrate surface, the surface of the substrate was ground by removing the surface by a thickness of 5 µm. As a result, the substrate surface had a surface roughness (Ra) of 2.5 nm. On the substrate surface having undergone the grinding process, the YSZ as the intermediate layer was deposited by pulsed laser deposition to a thickness of 1 µm. Then, the upper surface of the YSZ as the intermediate layer was ground by CMP by removing the surface by a thickness of 0.25 µm. Further, on the YSZ as the intermediate layer having undergone the grinding process, the HoBCO superconducting layer was deposited by pulsed laser deposition to a thickness of 0.25 µm.

As seen from Table 1, the value of the surface roughness of the YSZ as the intermediate layer is smaller in Examples 1, 2 as compared with that of the Comparative Example. Further, a comparison of the surface roughness of the YSZ as the intermediate layer between Example 1 and Example 2 shows that the value in Example 2 is smaller than that of Example 1. The reason therefor seems to be that, by grinding the substrate surface, the value of the surface roughness of the substrate serving as the underlying layer in Example 2 is allowed to be smaller than that of Example 1.

It is also seen from Table 1 that the value of the full width at half-maximum of the YSZ layer serving as the intermediate layer in Examples 1 and 2 is smaller than that in the Comparative Example. In addition, the value of the half width of the YSZ layer serving as the intermediate layer is smaller in Example 2 than Example 1. In other words, it is seen that the sample in Example 2 is most excellent in crystal orientation of the YSZ layer. Here, the half width (ΔΦ) refers to a characteristic value measured by the X-ray pole figure measurement that is a characteristic value indicating the crystal orientation of the YSZ layer.

Further, the critical current density of the superconducting layer was measured for each of the Comparative Example and Examples 1 and 2. As a result, as seen from Table 1, the critical current density of the superconducting layer in the Comparative Example is 0 while that is 0.7 in Example 1 and is 2.1 in Example 2. In other words, it is seen that the critical current density is larger in Example 2 than that in Example 1.

### Example 2

As a preferred example of the thin film material of the present invention, a superconducting wire 1 as shown in Fig. 10 was produced. With reference to Fig. 10, a description is given of superconducting wire 1 according to the present invention.

As shown in Fig. 10, superconducting wire 1 of the present invention has a first intermediate layer 3c formed on a substrate 2. A second intermediate layer 3d is formed on the first intermediate layer 3c. A lower intermediate layer 3 a is comprised of the first intermediate layer 3c and the second intermediate layer 3d. On the second intermediate layer 3d, an upper intermediate layer 3b is formed. On upper intermediate layer 3b, a superconducting layer 4 is formed.

The upper surface of substrate 2 is a ground surface 20 that has been ground. The upper surface of the second intermediate layer 3d (namely the upper surface of lower intermediate layer 3 a) is a ground surface 10 that has been ground. As a method of grinding, CMP is used as described in connection with Example 1. Instead, another arbitrary grinding method may be employed.

As substrate 2, the Ni alloy substrate is used as an example of the metal substrate. Further, as a material for the first intermediate layer 3c, ceria (cerium oxide) is used. This first intermediate layer 3c is a so-called seed layer for providing good orientation to the second intermediate layer 3d for example, and another material may also be used for the first intermediate layer. The first intermediate layer 3c may have thickness T1 of at most 1 µm for example.

As a material for the second intermediate layer 3d, YSZ is used. The second intermediate layer 3d is formed as an anti-diffusion layer for preventing elements that are constituents of superconducting layer 4 formed above from diffusing toward substrate 2. In order to allow this anti-diffusion capability to surely be exhibited, thickness T2 of the second intermediate layer 3d is set to be relatively larger than respective thicknesses of other intermediate layers (thickness T1 of the first intermediate layer 3c and thickness T3 of upper intermediate layer 3b). For example, thickness T2 of the second intermediate layer 3d may be at most 4 µm. As a material for the second intermediate layer 3d, any arbitrary material may be used instead of YSZ.

As a material for upper intermediate layer 3b, ceria (cerium oxide) for example is used. Upper intermediate layer 3b is so-called lattice-matched layer and is provided with the purpose of forming a layer having a lattice constant relatively close to the lattice constant of superconducting layer 4 so as to form superconducting layer 4 with good orientation on the upper surface of the upper intermediate layer. Thickness T3 of upper intermediate layer 3b may be at most 1 µm for example. As a material for upper intermediate layer 3b, any arbitrary material may be used instead of ceria.

As superconducting layer 4, the HoBCO superconducting layer is used. This HoBCO superconducting layer is deposited by pulsed laser deposition as done for the sample of Example 1. The thickness of the HoBCO superconducting layer may be 0.25 µm for example.

The upper surface of substrate 2 is ground surface 20 that has been ground using for example CMP and that may have a surface roughness (Ra) of 2.5 nm for example. Thus, the upper surface of substrate 2 is ground surface 20 and accordingly the planarity of the upper surface of substrate 2 serving as an underlying layer of intermediate layer 3 (second intermediate layer 3d for example) can be ensured. As a result, the initial surface roughness of the surface to be ground of intermediate layer 3 can be reduced. Therefore, in the case where the (upper) surface of intermediate layer 3 (second intermediate layer 3d for example) is ground to achieve a predetermined surface roughness, an amount of grinding can be reduced and thus the time required for the manufacturing process of the superconducting wire can be shortened. Further, since the upper surface of substrate 2 serving as an underlying layer is ground surface 20 with good planarity, the orientation of the intermediate layer (particularly lower intermediate layer 3a) can be improved.

Furthermore, the upper surface of the second intermediate layer 3d is also ground surface 10 having undergone the grinding process using CMP for example. The surface roughness (Ra) of the second intermediate layer 3d may be for example 2.1 nm. Thus, the upper surface of the second intermediate layer 3d is ground surface 10 so that the layer formed on the second intermediate layer 3d (upper intermediate layer 3b and superconducting layer 4) can be improved in orientation.

In addition, the second intermediate layer 3d serves as an anti-diffusion layer and thus has relatively large thickness T2 as described above. In the case where film thickness T2 is thus large, the planarity of the upper surface of the second intermediate layer 3 d tends to be worse as film thickness T2 is larger. In other words, under the condition that respective underlying layers of the first intermediate layer 3c, the second intermediate layer 3d and upper intermediate layer 3b are the same, the upper surface of the second intermediate layer 3d tends to have the largest surface roughness. Therefore, the upper surface of the second intermediate layer 3d that has the largest surface roughness (the worst planarity) can be ground to provide ground surface 10 so as to most effectively obtain intermediate layer 3 having excellent planarity.

Moreover, the upper surface of the second intermediate layer 3d (ground surface 10) could have strain accumulated due to the grinding process. Presence of such a defect as strain could influence orientation for example of superconducting layer 4 in the case where superconducting layer 4 is formed directly on this ground surface 10. Therefore, upper intermediate layer 3b is formed on ground surface 10 and superconducting layer 4 is formed on this upper intermediate layer 3b. Thus, even if such a defect is present in ground surface 10, film properties (such a property as orientation) of superconducting layer 4 can be prevented from being influenced.

In superconducting wire 1 shown in Fig. 10, only the upper surface of the second intermediate layer 3d may be ground. If thickness T2 of the second intermediate layer 3d is sufficiently small for example, only the upper surface of substrate 2 may be ground to form ground surface 20.

In addition, upper surface 30 of the first intermediate layer 3c or upper surface 40 of upper intermediate layer 3b for example may be ground to provide a ground surface. For example, upper surface 30 of the first intermediate layer 3c may be a ground surface to further improve the orientation of the second intermediate layer 3d and upper intermediate layer 3b. Further, the planarity of the upper surface in the initial state of the second intermediate layer 3d for example formed on the first intermediate layer 3c can be improved, so that the amount of grinding can be reduced in the grinding process for grinding the upper surface of the second intermediate layer 3d with the purpose of providing a predetermined surface roughness. Moreover, when upper surface 40 of upper intermediate layer 3b is provided as a ground surface, the orientation of superconducting layer 4 can further be improved.

It should be considered that embodiments and examples disclosed here are presented in all respects by way of illustration and example, not by way of limitation. It is intended that the scope of the present invention is defined not by the embodiments but by claims and involves all modifications in the meaning and range equivalent to the claims.

### Industrial Applicability

The present invention is applicable to a thin film material having a single-crystal thin film layer. In particular, the invention is applicable to a thin film material having such a single-crystal thin film layer as superconducting layer required to be excellent in such properties as surface smoothness and in-plane orientation.

## Claims

1. A thin film material (1) comprising:
a substrate (2);
an intermediate thin film layer (3) formed on said substrate (2) and comprised of one layer or at least two layers; and
a single-crystal thin film layer (4) formed on said intermediate thin film layer (3), wherein
an upper surface (10) that is an upper surface of at least one layer of said intermediate thin film layer (3) and that is opposite to said single-crystal thin film layer (4) is ground.

2. A thin film material (1) comprising:
a substrate (2);
an intermediate thin film layer (3) formed on said substrate (2) and comprised of one layer or at least two layers; and
a single-crystal thin film layer (4) formed on said intermediate thin film layer (3), wherein
a surface (10) that is a surface of said intermediate thin film layer and that is in contact with said single-crystal thin film layer is ground.

3. A thin film material (1) comprising:
a substrate (2);
an intermediate thin film layer (3) including a lower intermediate thin film layer (3a) formed on said substrate (2) and comprised of one layer or at least two layers and an upper intermediate thin film layer (3b) formed on said lower intermediate thin film layer (3a) and comprised of one layer or at least two layers; and
a single-crystal thin film layer (4) formed on said intermediate thin film layer (3), wherein
a surface (10) that is a surface of said lower intermediate thin film layer (3a) and that is in contact with said upper intermediate thin film layer (3b) is ground.

4. The thin film material according to any of claims 1 to 3, wherein
an upper surface (20) of said substrate (2) that is an upper surface opposite to said intermediate thin film layer (3) is ground.

5. The thin film material according to any of claims 1 to 3, wherein
said single-crystal thin film layer (4) is a superconducting thin film layer.

6. The thin film material according to claim 5, wherein
said substrate (2) is made of a metal,
said intermediate thin film layer (3) is made of an oxide having a crystal structure of one of rock salt type, fluorite type, perovskite type and pyrochlore type, and
said superconducting thin film layer (4) is made of an RE-123 type superconductor.

7. A method of manufacturing a thin film material, comprising the steps of:
preparing a substrate (2) (S10);
forming an intermediate thin film layer (3) comprised of one layer or at least two layers on said substrate (2) (S20, S21, S22);
processing by grinding an uppermost surface of said intermediate thin film layer (3) (S30); and
forming a single-crystal thin film layer (4) on the uppermost surface of said intermediate thin film layer (3) that is ground in said processing step (S40).

8. A method of manufacturing a thin film material, comprising the steps of:
preparing a substrate (2) (S10);
forming a lower intermediate thin film layer (3a) comprised of one layer or at least two layers on said substrate (2) (S21);
processing by grinding an uppermost surface of said lower intermediate thin film layer (3a) (S30);
forming an upper intermediate thin film layer (3b) comprised of one layer or at least two layers on the uppermost surface of said lower intermediate thin film layer (3a) that is ground in said processing step (S30) (S22); and
forming a single-crystal thin film layer (4) on said upper intermediate thin film layer (3b) (S40).

9. The method of manufacturing a thin film material according to claim 7 or 8, further comprising the substrate processing step (S50) for grinding a surface of said substrate.

10. The method of manufacturing a thin film material according to claim 7 or 8, wherein
said step of forming said single-crystal thin film layer (S40) is the step of forming a superconducting thin film layer.
